# EUROPEAN PATENT SPECIFICATION

(11) **EP 0 892 083 B1**
(45) Date of publication and mention of the grant of the patent: **19.03.2003**
(21) Application number: 98107962.7
(22) Date of filing: 30.04.1998
(51) Int. Cl.: C23C 16/44, C23C 16/40, H01L 21/00

(54) **Method and apparatus for seasoning a substrate processing chamber**
Verfahren und Vorrichtung zum Vorbeschichten einer Kammer zur Behandlung von Substraten
Procédé et appareillage de préparation d'une chambre pour le traitement des substrats

(30) Priority: 02.07.1997 US 887239
(43) Date of publication of application: 20.01.1999
(73) Proprietor: Applied Materials, Inc., Santa Clara, California 95052 (US)
(72) Inventor: Qiao, Jianmin, Fremont, CA 94539 (US); Chan, Chiu, Foster City, CA 94404 (US); Chan, Diana, San Jose, CA 95135 (US); Leung, Cissy S., Fremont, CA 94539 (US); Sahin, Turgut, Cupertino, CA 95014 (US)
(74) Representative: Kirschner, Klaus Dieter, Dipl.-Phys.

(56) References cited:
- EP-A- 0 387 656
- WO-A-97/18583
- WO-A-97/23663
- US-A- 5 221 414

## Description

The present invention relates to a method and an apparatus for seasoning a substrate processing chamber.

During chemical vapor deposition (CVD) of silicon oxide and other layers onto the surface of a substrate, the deposition gases released inside the processing chamber may cause unwanted deposition on areas such as the walls of the processing chamber. Unless removed, this unwanted deposition is a source of particles that may interfere with subsequent processing steps and adversely effect wafer yield.

To avoid such problems, the inside surface of the chamber is regularly cleaned to remove the unwanted deposition material from the chamber walls and similar areas of the processing chamber. This procedure is performed as a standard chamber dry clean operation where an etchant gas, such as nitrogen trifluoride (NF₃), is used to remove (etch) the deposited material from the chamber walls and other areas. During the dry clean operation, the chamber interior is exposed to a plasma from the etchant gas so that the etchant gas reacts with and removes the deposited material from the chamber walls. Such cleaning procedures are commonly performed between deposition steps for every wafer or every n wafers.

The clean step can, in itself, be a source of particle accumulation, however. Fluorine from the clean plasma can be absorbed and/or trapped in the chamber walls and in other areas of the chamber such as areas that include ceramic lining or other insulation material. The trapped fluorine can be released during subsequent processing steps (e.g., by reacting with constituents from the plasma in a high density plasma CVD (HDP-CVD) step) and can be absorbed in subsequently deposited silicon oxide or other layers.

To prevent such fluorine absorbtion and to provide protection against other contaminants within the chamber walls, e.g., the diffusion of metal fluorides, a CVD chamber is often "seasoned" after the dry clean operation. Such seasoning includes depositing a thin silicon oxide layer over the chamber walls before a substrate is introduced into the chamber for processing. The deposited silicon oxide layer covers the chamber walls reducing the likelihood that contaminates will interfere with subsequent processing steps. After deposition of the seasoning layer is complete, the chamber is used for one to n substrate deposition steps before being cleaned by another clean operation as described above and then reseasoned.

One particular method used to season some deposition chambers, such as the HDP-CVD chamber manufactured by Applied Materials and made primarily from aluminum includes forming a plasma from a process gas of silane (SiH₄), oxygen (O₂) and argon (Ar). The preferred flow ratio of O₂ to SiH₄ used in this method was 1.375:1. (O₂ was introduced at 110 seem, SiH₄ was introduced at 80 sccm and Ar was introduced at 20 sccm.) This seasoning process has been used to adequately protect subsequent processing steps from contaminants in the HDP-CVD chamber mentioned above as well as in other chambers.

Semiconductor device geometries have dramatically decreased in size since such devices were first introduced several decades ago. Since then, integrated circuits have generally followed the two year/half-size rule (often called "Moore's Law") which means that the number of devices which will fit on a chip doubles every two years. Today's wafer fabrication plants are routinely producing integrated circuits having 0.5 and even 0.35 micron feature sizes, and tomorrow's plants soon will be producing devices having even smaller geometries.

As device sizes become smaller and integration density increases, issues which were not previously considered important by the industry are becoming of concern. Also, improved control over criteria such as particle generation and contaminate control is necessary to ensure that deposited layers meet stringent manufacturers specifications. In order to meet processing demands created by such small scale geometry devices, new technology for substrate processing equipment is constantly being developed. In some of the new technology, a large percentage of the interior surfaces of deposition chambers is made from or coated with a ceramic material. For example, in the newer Ultima HDP-CVD chamber manufactured by Applied Materials, Inc., approximately 50% of the interior surface of the chamber is ceramic rather than aluminum or some other conductive material.

In some instances, procedures used with prior substrate processing equipment no longer provide optimal results with new reactor technology such as ceramic chambers.

Accordingly, it is the object of the invention to provide new techniques for working with and operating such new reactor technology.

The invention provides a method and an apparatus for improving the quality of films deposited in a substrate processing chamber by reducing particles in the chamber and improving contamination control. More particularly, the present invention provides a method of reducing the level of particles and other contaminants generated during deposition of films within a substrate processing chamber. The present invention is particularly useful in reducing particle count and contaminant levels in substrate processing equipment that includes an interior surface that is at least partially lined with ceramic or a similar material.

According to the present invention, a seasoning layer is deposited over a portion of the interior surface of the chamber by forming a plasma from a gas flow of O₂ and SiH₄ that is introduced into the chamber. The flow ratio of O₂ and SiH₄ is carefully controlled to between 1.4:1 and 2.4:1 O₂ to SiH₄. At these ratios the deposited seasoning layer is highly stable and is neither silicon-nor oxygen-rich as described in more detail below. In a preferred embodiment, argon (Ar) is introduced into the chamber along with the O₂ and SiH₄ and the flow ratio of O₂ to SiH₄ is between about 1.6:1 and 2.2:1.

Further preferred embodiments of the invention and the features thereof are given in the appended claims and subclaims.

Preferred embodiments of the invention will now be described in detail in conjunction with the accompanying drawings in which
Fig. 1A is a simplified diagram of one embodiment of a high density chemical vapor deposition system according to the present invention;
Fig. 1B is a simplified cross section of a gas ring that may be used in conjunction with the exemplary CVD processing chamber of Fig. 1A;
Fig. 1C is a simplified diagram of a monitor and light pen that may be used in conjunction with the exemplary CVD processing chamber of Fig. 1A;
Fig. 1D is a flow chart of an exemplary process control computer program product used to control the exemplary CVD processing chamber of Fig. 1A;
Fig. 2 is a flow chart illustrating the process used to form a seasoning film according to an embodiment of the method of present invention;
Fig. 3 is a graph showing the effect of O₂/SiH₄ flow ratio on the number of particles generated during substrate processing; and
Figs. 4A-4C are graphs depicting an FTIR analysis of seasoning films deposited with and without the benefit of the method of the present invention.

### I. Introduction

The present invention provides for deposition of a stable seasoning layer on the interior of a substrate processing chamber, such as a CVD chamber. The deposited seasoning layer has improved adhesion properties that allows it to adhere well to materials such as ceramic that are prevalent in some substrate processing chambers. The improved adhesion properties of the seasoning layer of the present invention allow improved quality silicon oxide, fluorosilicate glass and other films to be deposited within the substrate processing chamber. The present invention can be used to reduce contaminants in insulation and other layers deposited in CVD chambers of conventional design and processing steps employed in other substrate processing chambers.

### II. Exemplary Substrate Processing System

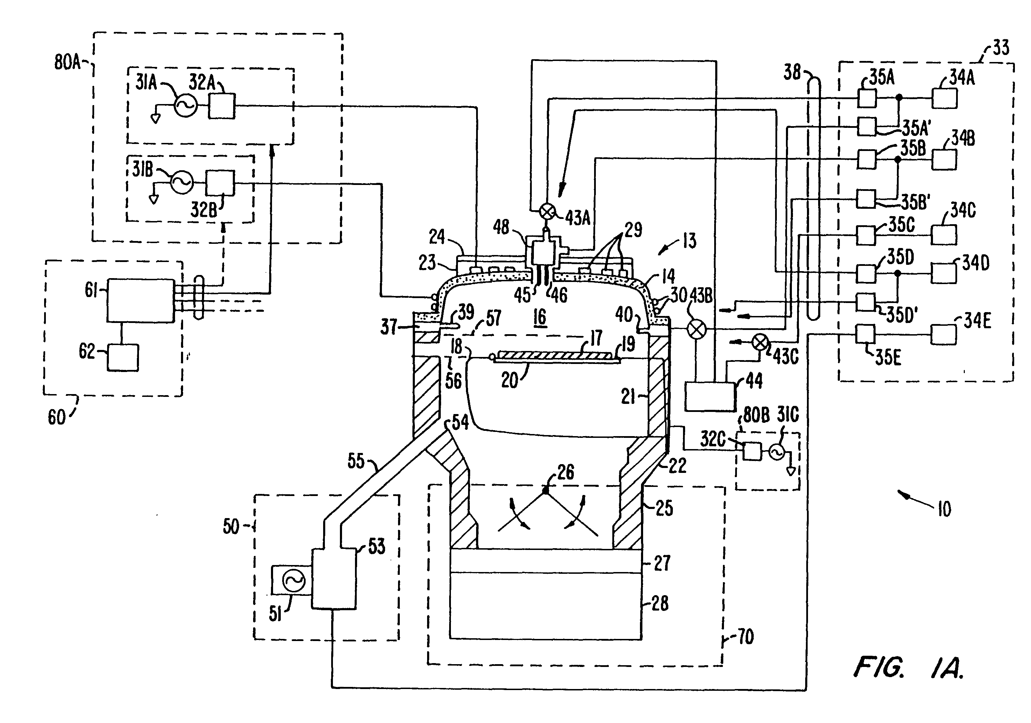

Fig. 1A illustrates one embodiment of a high density plasma chemical vapor deposition (HDP-CVD) system 10 in which a dielectric layer according to the present invention can be deposited. System 10 includes a chamber 13, a vacuum system 70, a source plasma system 80A, a bias plasma system 80B, a gas delivery system 33, and a remote plasma cleaning system 50.

The upper portion of chamber 13 includes a dome 14, which is made of a dielectric material, such as alumina or aluminum nitride. Dome 14 defines an upper boundary of a plasma processing region 16. Plasma processing region 16 is bounded on the bottom by the upper surface of substrate 17 and the substrate support member 18.

A heater plate 23 and a cold plate 24 surmount, and are thermally coupled to, dome 14. Heater plate 23 and cold plate 24 allow control of the dome temperature to within about ± 10 °C over a range of about 100 °C to 200 °C. This allows optimizing the dome temperature for the various processes. For example, it may be desirable to maintain the dome at a higher temperature for cleaning or etching processes than for deposition processes. Accurate control of the dome temperature also reduces the flake or particle counts in the chamber and improves adhesion between the deposited layer and the substrate.

The lower portion of chamber 13 includes a body member 22, which joins the chamber to the vacuum system. A base portion 21 of substrate support member 18 is mounted on, and forms a continuous inner surface with, body member 22. Substrates are transferred into and out of chamber 13 by a robot blade (not shown) through an insertion/removal opening (not shown) in the side of chamber 13. Lift pins (not shown) are raised and then lowered under the control of a motor (also not shown) to move the substrate from the robot blade at an upper loading position 57 to a lower processing position 56 in which the substrate is placed on a substrate receiving portion 19 of substrate support member 18. Substrate receiving portion 19 includes an electrostatic chuck 20 that secures the substrate to substrate support member 18 during substrate processing.

Vacuum system 70 includes throttle body 25, which houses twin-blade throttle valve 26 and is attached to gate valve 27 and turbo-molecular pump 28. It should be noted that throttle body 25 offers minimum obstruction to gas flow, and allows symmetric pumping. Gate valve 27 can isolate pump 28 from throttle body 25, and can also control chamber pressure by restricting the exhaust flow capacity when throttle valve 26 is fully open. The arrangement of the throttle valves, gate valve, and turbomolecular pump allow accurate and stable control of chamber pressures from between about 0,13 pa to 266,6 pa (1 millitorr to 2 torr).

The source plasma system 80A includes a top coil 29 and side coil 30, mounted on dome 14. A symmetrical ground shield (not shown) reduces electrical coupling between the coils. Top coil 29 is powered by top source RF (SRF) generator 31A, while side coil 30 is powered by side SRF generator 31B, allowing independent power levels and frequencies of operation for each coil. This dual coil system allows control of the radial ion density in chamber 13, thereby improving plasma uniformity. Side coil 30 and top coil 29 are typically inductively driven, which does not require a complimentary electrode. In a specific embodiment, the top source RF generator 31A provides up to 2,500 watts of RF power at nominally 2 MHz and the side source RF generator 31B provides up to 5,000 watts of RF power at nominally 2 MHz. The operating frequencies of the top and side RF generators may be offset from the nominal operating frequency (e.g. to 1.7-1.9 MHz and 1.9-2.1 MHz, respectively) to improve plasma-generation efficiency.

A bias plasma system 80B includes a bias RF (BRF) generator 31C and a bias matching network 32C. The bias plasma system 80B capacitively couples substrate portion 17 to body member 22, which act a complimentary electrodes. The bias plasma system 80B serves to enhance the transport of plasma species (i.e., ions) created by the source plasma system 80A to the surface of the substrate. In a specific embodiment, bias RF generator provides up to 5,000 watts of RF power at 13.56 MHz.

RF generators 31A and 31B include digitally-controlled synthesizers and operate over a frequency range between about 1.8 to about 2.1 MHz. Each generator includes an RF control circuit (not shown) that measures reflected power from the chamber and coil back to the generator, and adjusts the frequency of operation to obtain the lowest reflected power, as understood by a person of ordinary skill in the art. RF generators are typically designed to operate into a load with a characteristic impedance of 50 ohms. RF power may be reflected from loads that have a different characteristic impedance than the generator. This can reduce power transferred to the load. Additionally, power reflected from the load back to the generator may overload and damage the generator. Because the impedance of a plasma may range from less than 5 ohms to over 900 ohms, depending on the plasma ion density, among other factors, and because reflected power may be a function of frequency, adjusting the generator frequency according to the reflected power increases the power transferred from the RF generator to the plasma and protects the generator. Another way to reduce reflected power and improve efficiency is with a matching network.

Matching networks 32A and 32B match the output impedance of generators 31A and 31B with their respective coils 29 and 30. The RF control circuit may tune both matching networks by changing the value of capacitors within the matching networks to match the generator to the load as the load changes. The RF control circuit may tune a matching network when the power reflected from the load back to the generator exceeds a certain limit. One way to provide a constant match, and effectively disable the RF control circuit from tuning the matching network, is to set the reflected power limit above any expected value of reflected power. This may help stabilize a plasma under some conditions by holding the matching network constant at its most recent condition.

Other measures may also help stabilize a plasma. For example, the RF control circuit can be used to determine the power delivered to the load (plasma) and may increase or decrease the generator output power to keep the delivered power substantially constant during deposition of a layer.

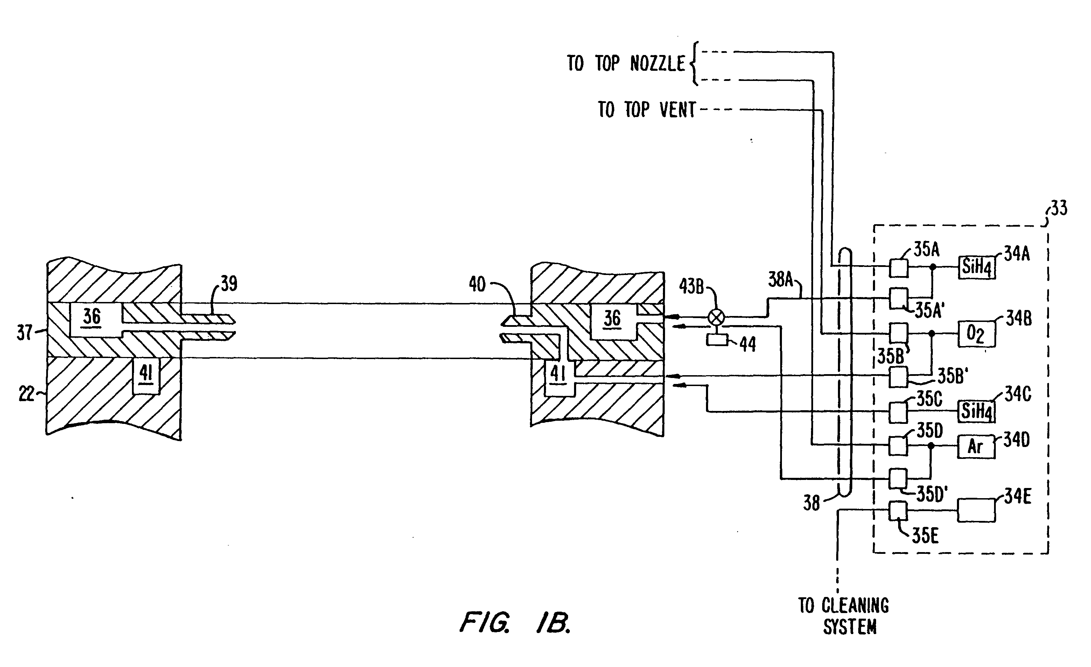

A gas delivery system 33 provides gases from several sources to the chamber for processing the substrate via gas delivery lines 38 (only some of which are shown). Gases are introduced into chamber 13 through a gas ring 37 and a top nozzle 45. Fig. 1B is a simplified, partial cross-sectional view of chamber 13 showing additional details of gas ring 37.

In one embodiment, first and second gas sources, 34A and 34B, and first and second gas flow controllers, 35A' and 35B', provide gas to ring plenum 36 in gas ring 37 via gas delivery lines 38 (only some of which are shown). Gas ring 37 has a plurality of source gas nozzles 39 (only one of which is shown) that provide a uniform flow of gas over the substrate. Nozzle length and nozzle angle may be changed to allow tailoring of the uniformity profile and gas utilization efficiency for a particular process within an individual chamber. In a preferred embodiment, gas ring 37 has 12 source gas nozzles.

Gas ring 37 also has a plurality of oxidizer gas nozzles 40 (only one of which is shown), which in a preferred embodiment are co-planar with, and shorter than, source gas nozzles 39, and in one embodiment receive gas from body plenum 41. In some embodiments it is desirable not to mix source gases and oxidizer gases before injecting the gases into chamber 13. In other embodiments, oxidizer gas and source gas may be mixed prior to injecting the gases into chamber 13 by providing apertures (not shown) between body plenum 41 and gas ring plenum 36. In one embodiment, third and fourth gas sources, 34C and 34D, and third and fourth gas flow controllers, 35C and 35D', provide gas to body plenum via gas delivery lines 38. Additional valves, such as 43B (other valves not shown), may shut off gas from the flow controllers to the chamber.

In some embodiments, flammable, toxic, or corrosive gases, such as silane or silicon tetrafluoride (SiF₄), may be used. In these instances, it may be desirable to eliminate gas remaining in the gas delivery lines after a deposition. This may be accomplished using a 3-way valve, such as valve 43B, to isolate chamber 13 from delivery line 38A and vent delivery line 38A to vacuum foreline 44, for example. As shown in Fig. 1A, other similar valves, such as 43A and 43C, may be incorporated on other gas delivery lines, such as 35A and 35C. Such 3-way valves may be placed as close to chamber 13 as practical, to minimize the volume of the unvented gas delivery line (between the 3-way valve and the chamber). Additionally, two-way (on-off) valves (not shown) may be placed between an MFC and the chamber or between a gas source and an MFC.

Referring again to Fig. 1A, chamber 13 also has top nozzle 45 and top vent 46. Top nozzle 45 and top vent 46 allow independent control of top and side flows of the gases, which improves film uniformity and allows fine adjustment of the film's deposition and doping parameters. Top vent 46 is an annular opening around top nozzle 45. In one embodiment, first gas source 34A is a silane source that supplies source gas nozzles 39 and top nozzle 45. Source nozzle mass flow controller (MFC) 35A' controls the amount of silane delivered to source gas nozzles 39 and top nozzle MFC 35A controls the amount of silane delivered to top gas nozzle 45. Similarly, two MFCs 35B and 35B' may be used to control the flow of oxygen to both top vent 46 and oxidizer gas nozzles 40 from a single source of oxygen, such as source 34B. The gases supplied to top nozzle 45 and top vent 46 may be kept separate prior to flowing the gases into chamber 13, or the gases may be mixed in top plenum 48 before they flow into chamber 13. Separate sources of the same gas may be used to supply various portions of the chamber.

A remote microwave-generated plasma cleaning system 50 is provided to periodically clean deposition residues from chamber components. The cleaning system includes a remote microwave generator 51 that creates a plasma from a cleaning gas source 34E, such as molecular fluorine, nitrogen trifluoride, other fluorocarbons or equivalents, in reactor cavity 53. The reactive species resulting from this plasma are conveyed to chamber 13 through cleaning gas feed port 54 via applicator tube 55. The materials used to contain the cleaning plasma (e.g. cavity 53 and applicator tube 55) must be resistant to attack by the plasma. The distance between reactor cavity 53 and feed port 54 should be kept as short as practical, as the concentration of desirable plasma species may decline with distance from reactor cavity 53. Generating the cleaning plasma in a remote cavity allows the use of an efficient microwave generator and does not subject chamber components to the temperature, radiation, or bombardment of the glow discharge that may be present in an *in situ* plasma. Consequently, relatively sensitive components, such as electrostatic chuck 20, do not need to be covered, with a dummy wafer or otherwise protected, as may be required with an *in situ* plasma cleaning process.

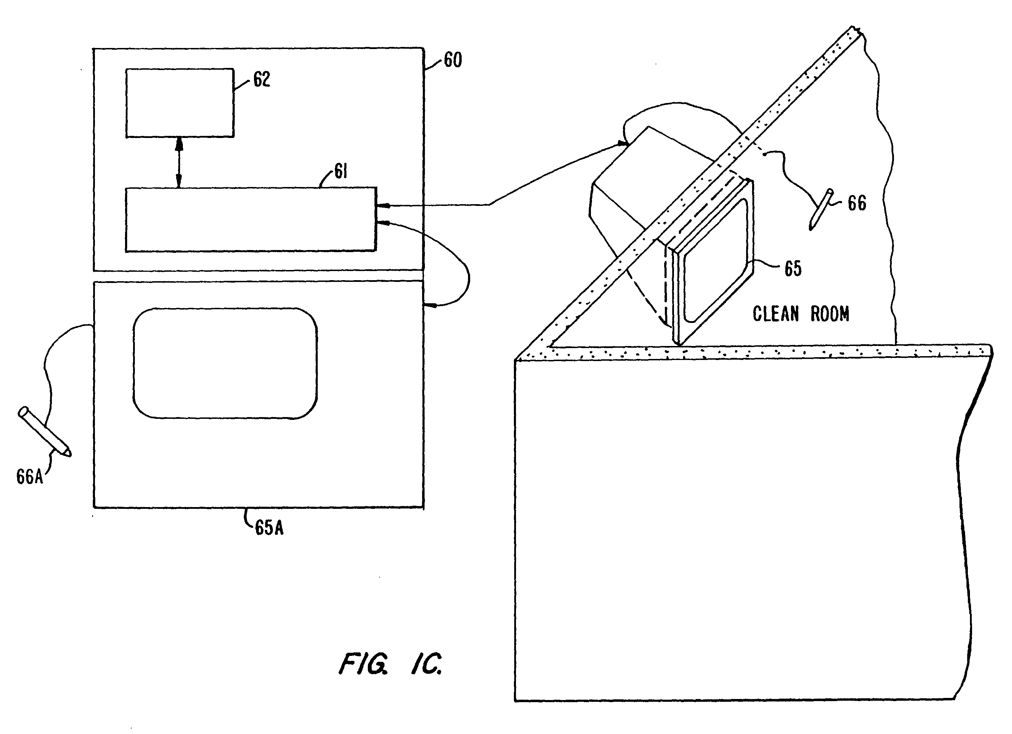

System controller 60 controls the operation of system 10. In a preferred embodiment, controller 60 includes a memory 62, such as a hard disk drive, a floppy disk drive (not shown), and a card rack (not shown). The card rack may contain a single-board computer (SBC) (not shown), analog and digital input/output boards (not shown), interface boards (not shown), and stepper motor controller boards (not shown). The system controller conforms to the Versa Modular European (VME) standard, which defines board, card cage, and connector dimensions and types. The VME standard also defines the bus structure having a 16-bit data bus and 24-bit address bus. System controller 31 operates under the control of a computer program stored on the hard disk drive or other computer programs, such as programs stored on a floppy disk. The computer program dictates, for example, the timing, mixture of gases, RF power levels and other parameters of a particular process. The interface between a user and the system controller is via a monitor, such as a cathode ray tube (CRT), 65, and a light pen 66, as depicted in Fig. 1C.

Fig. 1C is an illustration of a portion of an exemplary system user interface used in conjunction with the exemplary CVD processing chamber of Fig. 1A. System controller 60 includes a processor 61 coupled to a memory 62. Preferably, memory 62 may be a hard disk drive, but of course memory 62 may be other kinds of memory, such as ROM, PROM, and others.

System controller 60 operates under the control of a computer program. The computer program dictates the timing, temperatures, gas flows, RF power levels and other parameters of a particular process. The interface between a user and the system controller is via a CRT monitor 65 and a light pen 66, as depicted in Fig. 1C. In a preferred embodiment, two monitors, 65 and 65A, are used, one mounted in the clean room wall (65) for the operators and the other behind the wall (65A) for the service technicians. Both monitors simultaneously display the same information, but only one light pen (e.g. 66) is enabled. To select a particular screen or function, the operator touches an area of the display screen and pushes a button (not shown) on the pen. The touched area confirms being selected by the light pen by changing its color or displaying a new menu, for example.

The computer program code can be written in any conventional computer readable programming language such as 68000 assembly language, C, C++, or Pascal. Suitable program code is entered into a single file, or multiple files, using a conventional text editor, and stored or embodied in a computer-usable medium, such as a memory system of the computer. If the entered code text is in a high level language, the code is compiled, and the resultant compiler code is then linked with an object code of precompiled windows library routines. To execute the linked compiled object code, the system user invokes the object code, causing the computer system to load the code in memory, from which the CPU reads and executes the code to perform the tasks identified in the program.

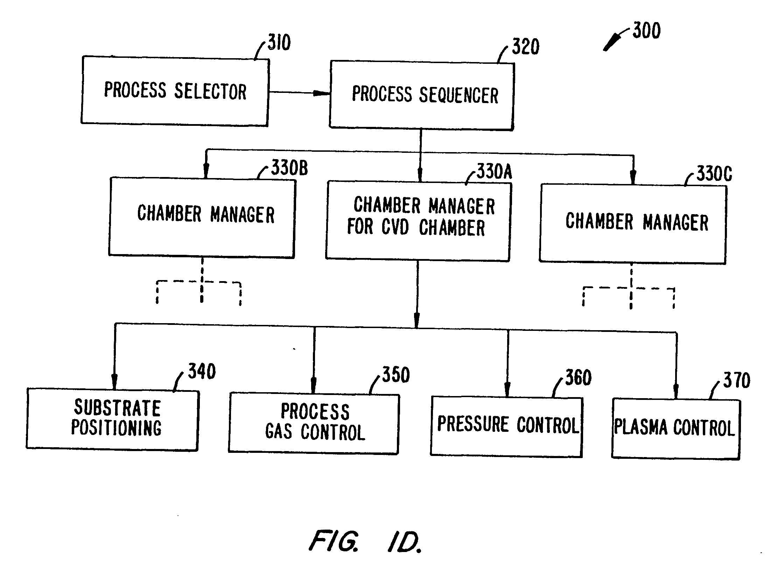

Fig. 1D shows an illustrative block diagram of the hierarchical control structure of computer program 300. A user enters a process set number and process chamber number into a process selector subroutine 310 in response to menus or screens displayed on the CRT monitor by using the light pen interface. The process sets are predetermined sets of process parameters necessary to carry out specified processes, and are identified by predefined set numbers. Process selector subroutine 310 identifies (i) the desired process chamber in a multichamber system, and (ii) the desired set of process parameters needed to operate the process chamber for performing the desired process. The process parameters for performing a specific process relate to process conditions such as, for example, process gas composition and flow rates, temperature, pressure, plasma conditions such as RF power levels, and chamber dome temperature, and are provided to the user in the form of a recipe. The parameters specified by the recipe are entered utilizing the light pen/CRT monitor interface.

The signals for monitoring the process are provided by the analog input and digital input boards of system controller and the signals for controlling the process are output on the analog output and digital output boards of system controller 60.

A process sequencer subroutine 320 comprises program code for accepting the identified process chamber and set of process parameters from the process selector subroutine 310, and for controlling operation of the various process chambers. Multiple users can enter process set numbers and process chamber numbers, or a user can enter multiple process set numbers and process chamber numbers, so sequencer subroutine 320 operates to schedule the selected processes in the desired sequence. Preferably, sequencer subroutine 320 includes a program code to perform the steps of (i) monitoring the operation of the process chambers to determine if the chambers are being used, (ii) determining what processes are being carried out in the chambers being used, and (iii) executing the desired process based on availability of a process chamber and type of process to be carried out. Conventional methods of monitoring the process chambers can be used, such as polling. When scheduling which process is to be executed, sequencer subroutine 320 can be designed to take into consideration the present condition of the process chamber being used in comparison with the desired process conditions for a selected process, or the "age" of each particular user entered request, or any other relevant factor a system programmer desires to include for determining scheduling priorities.

After sequencer subroutine 320 determines which process chamber and process set combination is going to be executed next, sequencer subroutine 320 causes execution of the process set by passing the particular process set parameters to a chamber manager subroutine 330A-C, which controls multiple processing tasks in chamber 13 and possibly other chambers (not shown) according to the process set determined by sequencer subroutine 320.

Examples of chamber component subroutines are substrate positioning subroutine 340, process gas control subroutine 350, pressure control subroutine 360, and plasma control subroutine 370. Those having ordinary skill in the art will recognize that other chamber control subroutines can be included depending on what processes are desired to be performed in chamber 13. In operation, chamber manager subroutine 330A selectively schedules or calls the process component subroutines in accordance with the particular process set being executed. Scheduling by chamber manager subroutine 330A is performed in a manner similar to that used by sequencer subroutine 320 in scheduling which process chamber and process set to execute. Typically, chamber manager subroutine 330A includes steps of monitoring the various chamber components, determining which components need to be operated based on the process parameters for the process set to be executed, and causing execution of a chamber component subroutine responsive to the monitoring and determining steps.

Operation of particular chamber component subroutines will now be described with reference to Fig. 1D. Substrate positioning subroutine 340 comprises program code for controlling chamber components that are used to load a substrate onto substrate support number 18. Substrate positioning subroutine 340 may also control transfer of a substrate into chamber 13 from, e.g., a PECVD reactor or other reactor in the multichamber system, after other processing has been completed.

Process gas control subroutine 350 has program code for controlling process gas composition and flow rates. Subroutine 350 controls the open/close position of the safety shut-off valves, and also ramps up/down the mass flow controllers to obtain the desired gas flow rates. All chamber component subroutines, including process gas control subroutine 350, are invoked by chamber manager subroutine 330A. Subroutine 350 receives process parameters from chamber manager subroutine 330A related to the desired gas flow rates.

Typically, process gas control subroutine 350 operates by opening the gas supply lines, and repeatedly (i) reading the necessary mass flow controllers, (ii) comparing the readings to the desired flow rates received from chamber manager subroutine 330A, and (iii) adjusting the flow rates of the gas supply lines as necessary. Furthermore, process gas control subroutine 350 may include steps for monitoring the gas flow rates for unsafe rates, and activating the safety shut-off valves when an unsafe condition is detected.

In some processes, an inert gas, such as argon, is flowed into chamber 13 to stabilize the pressure in the chamber before reactive process gases are introduced into the chamber. For these processes, the process gas control subroutine 350 is programmed to include steps for flowing the inert gas into chamber 13 for an amount of time necessary to stabilize the pressure in the chamber. The above-described steps may then be carried out.

Additionally, when a process gas is to be vaporized from a liquid precursor, for example, tetraethylorthosilane (TEOS), the process gas control subroutine 350 may include steps for bubbling a delivery gas such as helium through the liquid precursor in a bubbler assembly or for introducing the helium to a liquid injection valve. For this type of process, the process gas control subroutine 350 regulates the flow of the delivery gas, the pressure in the bubbler, and the bubbler temperature to obtain the desired process gas flow rates. As discussed above, the desired process gas flow rates are transferred to process gas control subroutine 350 as process parameters.

Furthermore, the process gas control subroutine 350 includes steps for obtaining the necessary delivery gas flow rate, bubbler pressure, and bubbler temperature for the desired process gas flow rate by accessing a stored table containing the necessary values for a given process gas flow rate. Once the necessary values are obtained, the delivery gas flow rate, bubbler pressure and bubbler temperature are monitored, compared to the necessary values and adjusted accordingly.

The process gas control subroutine 350 may also control the flow of heat-transfer gas, such as helium (He), through the inner and outer passages in the wafer chuck with an independent helium control (IHC) subroutine (not shown). The gas flow thermally couples the substrate to the chuck. In a typical process, the wafer is heated by the plasma and the chemical reactions that form the layer, and the He cools the substrate through the chuck, which may be water-cooled. This keeps the substrate below a temperature that may damage preexisting features on the substrate.

Pressure control subroutine 360 includes program code for controlling the pressure in chamber 13 by regulating the size of the opening of throttle valve in the exhaust portion of the chamber. There are at least two basic methods of controlling the chamber with the throttle valve. The first method relies on characterizing the chamber pressure as it relates to, among other things, the total process gas flow, size of the process chamber, and pumping capacity. The first method sets throttle valve 26 to a fixed position. Setting throttle valve 26 to a fixed position may eventually result in a steady-state pressure.

Alternatively, the chamber pressure may be measured, with a manometer for example, and throttle valve 26 position may be adjusted according to pressure control subroutine 360, assuming the control point is within the boundaries set by gas flows and exhaust capacity. The former method may result in quicker chamber pressure changes, as the measurements, comparisons, and calculations associated with the latter method are not invoked. The former method may be desirable where precise control of the chamber pressure is not required, whereas the latter method may be desirable where an accurate, repeatable, and stable pressure is desired, such as during the deposition of a layer.

When pressure control subroutine 360 is invoked, the desired, or target, pressure level is received as a parameter from chamber manager subroutine 330A. Pressure control subroutine 360 operates to measure the pressure in chamber 13 by reading one or more conventional pressure manometers connected to the chamber, compare the measure value(s) to the target pressure, obtain proportional, integral, and differential (PID) values from a stored pressure table corresponding to the target pressure, and adjust throttle valve 26 according to the PID values obtained from the pressure table. Alternatively, pressure control subroutine 360 may open or close throttle valve 26 to a particular opening size to regulate the pressure in chamber 13 to a desired pressure or pressure range.

Plasma control subroutine 370 comprises program code for controlling the frequency and power output setting of RF generators 31A and 31B, and for tuning matching networks 32A and 32B. Plasma control subroutine 370, like the previously described chamber component subroutines, is invoked by chamber manager subroutine 330A.

### III. Depositing Stable Seasoning Films

Prior to the present invention, a seasoning layer employed in the exemplary chamber described above (chamber 13) formed a plasma from a process gas that included SiH4, O₂ and Ar in the ratios described in the Background of the Invention section above (i.e., O₂ to SiH₄ flow ratio of 1.375:1). Tests determined that after chamber 13 was seasoned with such a seasoning layer a relatively high count of particles having a diameter of 0.5 µm or more were present within the chamber after films such as a fluorosilicate glass, silicon dioxide, phosphosilicate glass and silicon nitride were deposited over substrates disposed within the chamber.

Much effort was spent refining various steps and parameters of the processes used to deposit these films without any significant reduction in the particle count. The inventors of the present application then unexpectedly discovered that the primary source of the particles was not the CVD deposition process used to deposit the film over wafers disposed in the chamber. Instead, the source of these particles was discovered to be the silicon oxide seasoning film itself. The inventors discovered that the prior seasoning process resulted in deposition of a seasoning film that was not adhering properly to the chamber walls. The seasoning film therefore chipped- or peeled-off during subsequent wafer processing steps used to deposit a film over a substrate in the chamber. It is believed that the adhesion problems of the prior seasoning process were confined primarily to the ceramic portions of the chamber. Thus, it is believed that the particle problem was a direct result of the large percentage of ceramic used in chamber 13 (as previously noted, the interior of the chamber in which this seasoning process was previously employed was primarily quartz or silicon).

In response to this discovery, the inventors developed a seasoning film that adheres well to materials such as aluminum and also adheres well to materials such as ceramic. Thus, the present invention may be employed to reduce the amount of particles and other contaminants present during substrate processing that originate from walls or insulation areas in the interior of a substrate processing chamber, such as the exemplary chamber described, even when a relatively high percentage of these walls and insulation areas are made from ceramic or similar material. Compared to previous seasoning layers, the seasoning layer formed according to the present invention has improved adhesion to these ceramic portions of the substrate processing chamber and is therefore less susceptible to flaking or peeling during subsequent substrate processing.

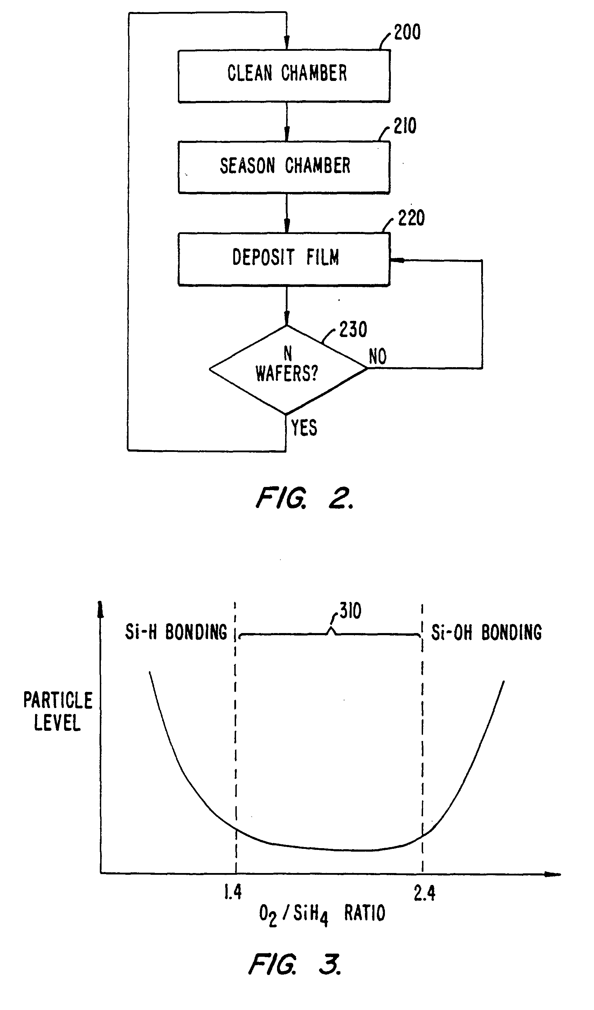

Fig. 2 illustrates a preferred process of the invention with cross-reference numerals referring to the apparatus shown in Fig. 1A. This process is implemented and controlled using a computer program stored in the memory 62 of CVD system 10. In this preferred embodiment, the seasoning layer is deposited after completion of a standard chamber clean operation (step 200) in which an etchant gas such as NF₃ is introduced into the chamber to remove material deposited on the chamber walls from a previous processing step (e.g., CVD deposition operations in step 220). Such a cleaning step may leave some residue (e.g., fluorine absorbed within the chamber walls) within the chamber that is covered by the seasoning film so that the residue is not released during a subsequent deposition step (e.g., deposition step 220). After the seasoning film has been deposited, between 1 to n substrates are processed within chamber 13 before the entire sequence is repeated (step 230).

The seasoning layer is deposited (step 210) by forming a plasma from a gas that includes SiH₄, O₂ and argon. The plasma is formed by application of RF energy from SRF generators 32A and 32B. Preferably, the plasma is not biased toward the substrate and thus BRF generator 32C is not switched on.

To ensure that the deposited film adheres well to the interior of chamber 13, it is important to control a number of deposition parameters including: temperature, pressure, RF power levels, the ratio of argon to O₂ and the ratio of O₂ to SiH₄. The inventors have found that one of the most important of these parameters is the O₂ to SiH₄ ratio. Introducing too much SiH₄ or too little O₂ into the process gas will result in a silicon oxide film that includes many Si-H bonds. Such a film is referred to as a silicon-rich film. Introducing too much O₂ or too little SiH₄, on the other hand, results in a silicon oxide film that includes many Si-OH bonds. Such a film is referred to as an oxygen-rich film.

As described in more detail below, the inventors have found that at a flow ratio of O₂ to SiH₄ of between 1.4-2.4:1 the resultant seasoning film is neither silicon- or oxygen-rich and thus exhibits improved adhesion to surfaces that are difficult to adhere to such as ceramic. The inventors have discovered that, more preferably, the ratio of O₂ to SiH₄ should be between 1.6-2.2:1.

The amount of argon flowed into the chamber also effects the adhesion properties of the deposited seasoning layer. Generally speaking, increasing the argon flow increases the plasma density, thereby providing a more effective seasoning film. If too much argon is flowed into the chamber, however, the pressure within the chamber will increase reducing plasma density instead of increasing it. An argon flow rate approximately equal to the SiH₄ flow rate is preferred.

In one preferred embodiment, O₂ is introduced into the chamber at a rate of 115 sccm from the side nozzles and at a rate of 25 sccm from top vent 46; SiH₄ is introduced at a rate of 70 sccm from the side nozzles and 5 sccm from the top nozzle; and argon is introduced at a rate of 78 sccm from the side and 15 sccm from the top nozzle. The total O₂ to SiH₄ ratio in this embodiment is 1.87:1. Additionally, pressure in the chamber is set to 0,8 pa (6 mtorr), and the side RF source is powered at 2500 W while the top RF source is powered at 1000 W.

Fig. 3 shows a graph of the number of particles (particles greater than 0.5 µm in diameter) generated during subsequent substrate processing versus the flow ratio of O₂ to SiH₄ in the seasoning film deposited in step 210. As evident from the graph, at a flow ratio of less 1 part SiH₄ to 1.4 part O₂ or greater than 1 part SiH₄ to 2.4 parts O₂ results in an elevated particle count. It is believed that a greater number of particles are generated at these flow ratios because the deposited seasoning layer does not adequately adhere to the ceramic portions of the chamber walls. Thus, the seasoning layer is prone to chip or peel off in tiny portions during subsequent substrate processing. It is believed that the poor adhesion is due to either the relatively large number of Si-H bonds (ratio less than 1.4:1 or the large number of Si-OH bonds (ratio larger than 2.4:1) incorporated in the silicon oxide seasoning film.

In contrast, at a O₂ to SiH₄ flow ratio of between 1.4-2.4:1, the silicon oxide seasoning layer adheres well to the chamber walls including the ceramic portions of the walls. Because of its better adhesion, particles are less likely to chip or peel-off during subsequent substrate processing steps employed within chamber 13 such as CVD deposition step 220. The reduced particle count is shown in Fig. 3 as area 310.

### III. Experimental Results

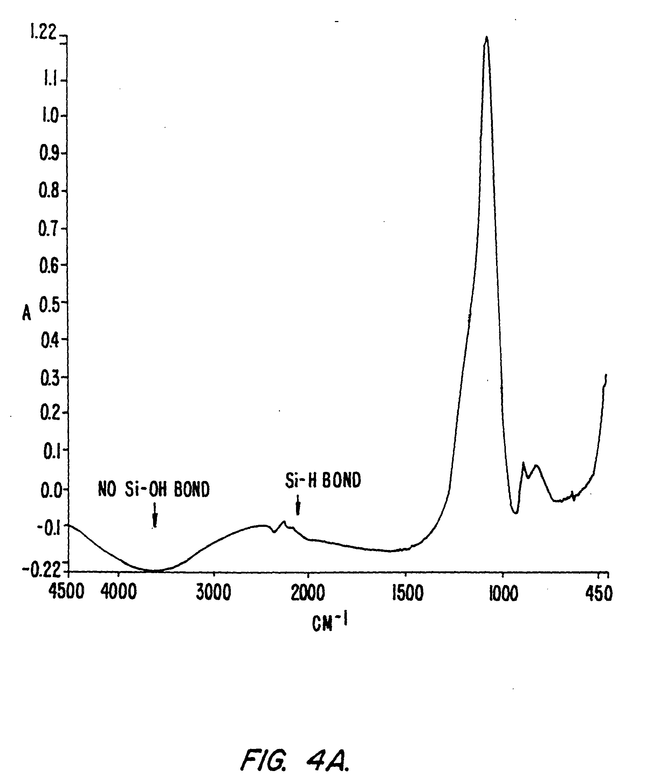

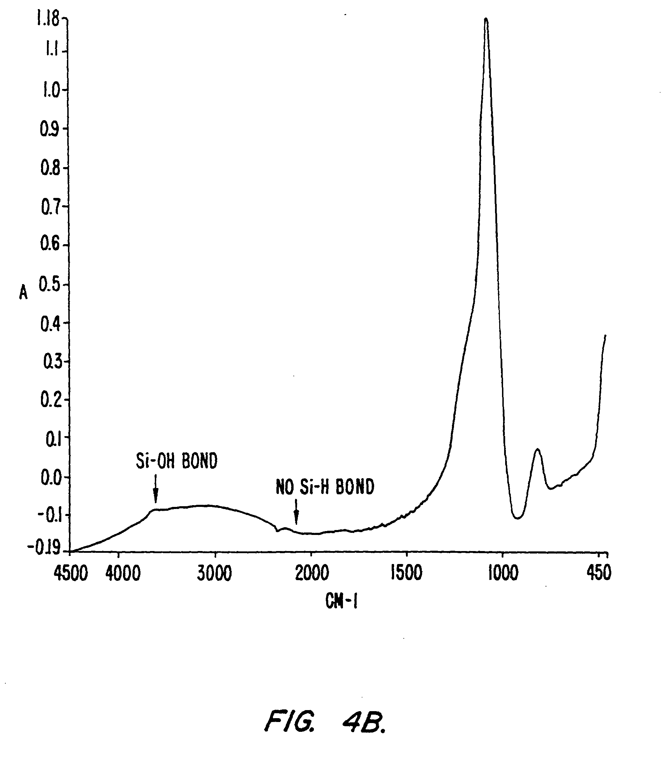

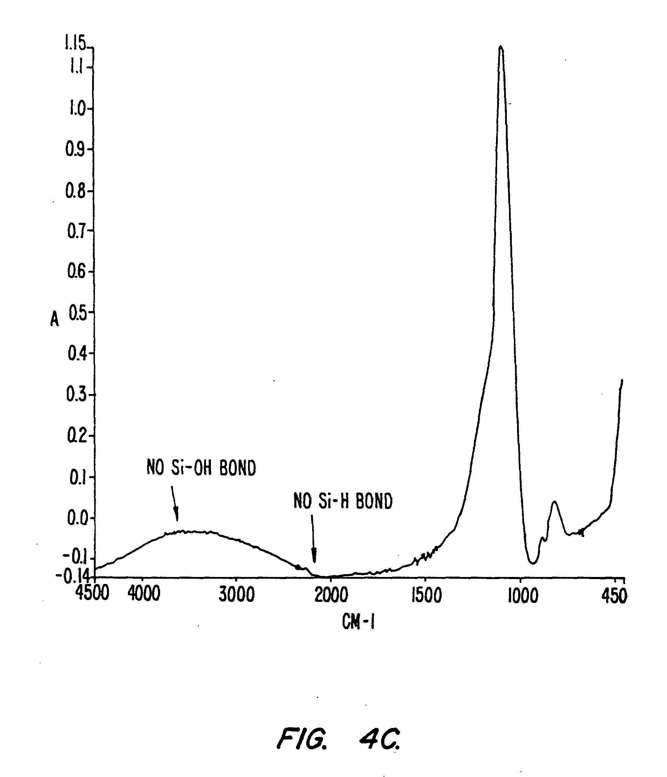

To demonstrate the operation of and prove the effectiveness of the present invention, experiments were performed comparing characteristics of seasoning films deposited according to a prior art process having a O₂ to SiH₄ ratio of about 1.3:1 to films having a higher O₂ to SiH₄ ratio. In each experiment, Fourier Transform Infrared Spectroscopy (FTIR) analysis was performed as known and understood by a person of ordinary skill in the art to detect the presence of Si-OH and Si-H bonds in each seasoning layer. The results of the FTIR analysis on the prior art film having an O₂ to SiH₄ ratio of about 1.3:1 are shown in Fig. 4A. As evident in Fig. 4A, the presence of Si-H bonds were detected indicating that the film is silicon-rich. FTIR analysis of another seasoning film having an O₂ to SiH₄ ratio of about 2.6:1 is shown in Fig. 4B. As evident in Fig. 4B, the presence of Si-OH bonds are detected in this seasoning film thus indicating the film is oxygen-rich. Fig. 4C presents FTIR analysis of a seasoning film that is neither oxygen- nor silicon-rich and that was deposited according to the method of the present invention from a process gas in which the ratio of O₂ to SiH₄ was about 1.8:1.

As shown in Fig. 4C, the number of Si-H and Si-OH bonds present in the deposited film are significantly reduced as compared to the number of such bonds in the films analyzed in Figs. 4A and 4B.

The above-described gas introduction rates and experiments are based on forming a seasoning layer of the present invention in an Ultima HDP-CVD chamber manufactured by Applied Materials that is outfitted for 8-inch wafers. As a person of ordinary skill in the art would understand, the actual rates at which gases are introduced in other embodiments will vary if other chambers of different designs and/or volume are employed. Also, the parameters listed in the above process should not be limiting to the claims as described herein. One of ordinary skill in the art can use chamber parameters and conditions other than those described. As such, the above description is illustrative and not restrictive. Merely by way of example, the invention is illustrated with particular reference to a seasoning film process that uses argon as an inert gas that helps stabilize deposition conditions and deposit a more stable seasoning layer. It is possible to use other inert gases, such as helium, to achieve similar results. Additionally, while currently not preferred, it is possible to include dopants such as boron, phosphorus or others in the silicon oxide seasoning layer in other embodiments. The scope of the invention should, therefore, be determined not with reference to the above description, but instead should be determined with reference to the appended claims along with their full scope of equivalents.

## Claims

1. A method of seasoning a substrate processing chamber, said method comprising the step of, prior to a substrate processing operation, flowing a seasoning gas comprising silane and oxygen into said chamber at a flow ratio of between 1.4:1 and 2.4:1 oxygen to silane to deposit a silicon oxide film over at least a portion of an interior surface of said chamber.

2. The method of claim 1, wherein said flow ratio of oxygen to silane is between about 1.6:1 and 2.2:1 oxygen to silane.

3. The method of claim 1 or 2, further comprising the step of, after deposition of said silicon oxide film, processing a substrate in said chamber.

4. The method of claim 3, wherein said silicon oxide film is deposited by applying energy to said seasoning gas to form a plasma from said process gas.

5. The method of any of the claims 1 to 4, wherein said at least a portion of an interior surface comprises a ceramic material.

6. The method of any of the claims 1 to 5, further comprising the step of, prior to flowing said seasoning gas into said chamber, cleaning material deposited on said at least a portion of an interior surface by flowing an etchant gas into said chamber to react said etchant gas with said material.

7. A substrate processing system comprising:
a housing for forming a vacuum chamber having an interior surface;
substrate holder, located within said housing, for holding a substrate;
a gas delivery system for introducing a seasoning gas into said vacuum chamber;
a controller for controlling said gas delivery system; and
memory coupled to said controller comprising a computer-readable medium having a computer-readable program embodied therein for directing operation of said chemical vapor deposition reactor system, said computer-readable program being **characterized by**:
a first set of instructions for, prior to a substrate processing operation, controlling said gas delivery system to flow a seasoning gas comprising oxygen and silane into said vacuum chamber at a flow ratio of between 1.4:1 and 2.4:1 oxygen to silane to deposit a silicon oxide film over at least a portion of said interior surface of said vacuum chamber.

8. A substrate processing system of claim 7, further comprising:
a substrate transfer system configured to transfer a substrate into said vacuum chamber and position said substrate on said substrate holder;
a plasma generation system configured to form a plasma from gases introduced into said vacuum chamber; and
a controller for controlling said substrate transfer system, said gas delivery system and said plasma generation system; **characterized by**:
a first set of instructions for controlling said gas delivery system to introduce an etchant gas into said vacuum chamber to clean said interior surface of said vacuum chamber;
second set of instructions to be executed after said first set of instructions for controlling said gas delivery system to flow a seasoning gas comprising oxygen and silane into said vacuum chamber at a flow ratio of between 1.4:1 and 2.4:1 oxygen to silane into said vacuum chamber;
third set of instructions for controlling said plasma generation system to form a plasma from said seasoning gas to deposit a silicon oxide film over at least a portion of said interior surface of said vacuum chamber;
fourth set of instructions to be executed after said second and third sets of instructions for controlling said substrate transfer system to transfer a substrate upon which one or more integrated circuits are to be formed into said vacuum chamber and position said substrate onto said substrate holder; and
fifth set of instructions for controlling said gas delivery system to introduce a deposition gas into said vacuum chamber to deposit a layer over said substrate.

## Patentansprüche

1. Verfahren zum Vorbeschichten einer Kammer zur Behandlung von Substraten, wobei das Verfahren den Schritt umfasst, dass vor der Substratbehandlung ein Vorbeschichtungsgas, das Silan und Sauerstoff umfasst, in die Kammer mit einer Flußrate von zwischen 1.4:1 und 2.4:1 Sauerstoff zu Silan einströmen gelassen wird, um einen Siliciumoxidfillm über wenigstens einem Teil einer Innenfläche der Kammer abzuscheiden.

2. Verfahren nach Anspruch 1, worin die Flußrate des Sauerstoffs zu Silan zwischen etwa 1.6:1 und 2.2:1 Sauerstoff zu Silan ist.

3. Verfahren nach Anspruch 1 oder 2, ferner umfassend den Schritt, dass nach der Abscheidung des Siliciumoxidfilms ein Substrat in der Kammer behandelt wird.

4. Verfahren nach Anspruch 3, worin der Siliciumoxidfilm dadurch abgeschieden wird, dass Energie an das Vorbeschichtungsgas angewendet wird, um ein Plasma von dem Prozessgas zu bilden.

5. Verfahren nach einem der Ansprüche 1 bis 4, worin wenigstens ein Teil einer Innenfläche ein Keramikmaterial umfasst.

6. Verfahren nach einem der Ansprüche 1 bis 5, ferner umfassend den Schritt, dass vor dem Einströmenlassen des Vorbeschichtungsgases in die Kammer ein Material auf wenigstens einem Abschnitt einer Innenfläche weg gereinigt wird, indem ein Ätzgas in die Kammer einströmen gelassen wird, um das Ätzgas mit dem Material reagieren zu lassen.

7. Kammer zur Behandlung eines Substrates umfassend:
ein Gehäuse zum Bilden einer Vakuumskammer mit einer Innenfläche;
einen Substrathalter, der in dem Gehäuse angeordnet ist, um ein Substrat zu halten;
ein Gasabgabesystem, um ein Vorbeschichtungsgas in die Vakuumkammer einzuführen;
einen Kontroller zum Steuern des Gasabgabesystems; und
einen mit dem Kontroller gekoppelten Speicher, der ein computerlesbares Medium umfasst, in dem ein computerlesbares Programm enthalten ist, um den Betrieb des Reaktorsystems für die chemische Abscheidung aus der Dampfphase zu steuern, wobei das computerlesbare Programm **gekennzeichnet ist durch**:
einen ersten Satz von Befehlen, um vor der Behandlung des Substrats das Gasabgabesystem zu kontrollieren, um ein Vorbeschichtungsgas, das Sauerstoff und Silan umfasst, in die Vakuumkammer mit einer Flußrate von zwischen 1.4:1 und 2.4:1 Sauerstoff zu Silan einfließen zu lassen, um einen Siliciumoxidfilm bei wenigstens einem Teil der Innenfläche der Vakuumkammer abzuscheiden.

8. Substratbehandlungssystem nach Anspruch 7, ferner umfassend:
ein Substrattransfersystem, welches konfiguriert ist, um ein Substrat in die Vakuumkammer zu überführen und das Substrat auf dem Substrathalter zu positionieren;
ein Plasmaerzeugungssystem, welches konfiguriert ist, um ein Plasma von den Gasen zu bilden, die in die Vakuumkammer eingeführt wurden; und
einen Kontroller zum Steuern des Substrattransferssystems, des Gasabgabesystems und des Plasmaerzeugungssystems, **gekennzeichnet durch**:
einen ersten Satz von Befehlen, um das Gasabgabesystem zu steuern, um ein Ätzgas in die Vakuumkammer einzuführen, um die Innenfläche der Vakuumkammer zu reinigen;
einen zweiten Satz von Befehlen, der nach dem ersten Satz von Befehlen auszuführen ist, um das Gasabgabesystem zu steuern, um ein Vorbeschichtungsgas, das Sauerstoff und Silan umfasst, in die Vakuumkammer mit einer Flußrate von zwischen 1.4:1 und 2.4:1 Sauerstoff zu Silan in die Vakuumkammer einströmen zu lassen;
einen dritten Satz von Befehlen, um das Plasmageneratorsystem zu steuern, um ein Plasma aus dem Vorbeschichtungsgas zu bilden, um einen Siliciumoxidfilm über wenigstens einem Teil der Innenfläche der Vakuumkammer abzuscheiden;
einen vierten Satz von Befehlen, der nach dem zweiten und dem dritten Satz von Befehlen auszuführen ist, um das Substrat, auf dem eine integrierte Schaltung oder mehrere integrierte Schaltungen ausgebildet werden sollen, in die Vakuumkammer zu überführen und das Substrat auf dem Substrathalter zu positionieren, und
einen fünften Satz von Befehlen, um das Gasabgabesystem zu steuern, um ein Abscheidungsgas in die Vakuumkammer einzuführen, um eine Schicht auf dem Substrat abzuscheiden.

## Revendications

1. Procédé de préparation d'une chambre pour le traitement des substrats ; ledit procédé comprenant l'étape de laisser s'écouler avant une opération de traitement des substrats un gaz de préparation comprenant du silane et de l'oxygène dans ladite chambre à une ratio de débit d'oxygène par rapport au silane compris entre 1,4 :1 et 2,4 : 1 pour déposer un film d'oxyde de silicone sur au moins une partie d'une surface intérieure de ladite chambre.

2. Procédé selon la revendication 1, où ledit ratio de débit d'oxygène par rapport au silane est compris entre 1,6 : 1 et 2,2 à 1 d'oxygène par rapport au silane.

3. Procédé selon la revendication 1 ou 2, comprenant en plus l'étape de traitement d'un substrat dans ladite chambre après le dépôt dudit film d'oxyde de silicone.

4. Procédé selon la revendication 3, où ledit film d'oxyde de silicone est déposé en appliquant de l'énergie audit gaz de préparation pour former un plasma à partir dudit gaz de traitement.

5. Procédé selon l'une quelconque des revendications 1 à 4, où au moins ladite partie d'une surface intérieure comprend un matériau en céramique.

6. Procédé selon l'une quelconque des revendications 1 à 5, comprenant en plus l'étape de nettoyage du matériau déposé - avant de laisser s'écouler ledit gaz de préparation dans ladite chambre - sur au moins une partie d'une surface intérieure en laissant s'écouler un gaz corrosif dans ladite chambre pour créer une réaction entre ledit gaz corrosif avec ledit matériau.

7. Un système de traitement de substrat comprenant :
- un boîtier pour créer une chambre à vide ayant une surface intérieure ;
- un porte-substrat situé dans ledit boîtier pour tenir le substrat ;
- un système de fourniture d'un gaz pour introduire un gaz de préparation dans ladite chambre à vide ;
- un contrôleur pour contrôler ledit système de fourniture de gaz ; et
- une mémoire associée audit contrôleur comprenant un moyen lisible par ordinateur ayant un programme lisible par ordinateur installé dedans pour diriger le fonctionnement dudit système de réacteur à dépôt de vapeur chimique ; ledit programme lisible par ordinateur étant **caractérisé par** :
- un premier jeu d'instructions pour contrôler avant l'opération de traitement de substrat ledit système de fourniture de gaz pour laisser s'écouler un gaz de préparation contenant de l'oxygène et du silane dans ladite chambre à vide à une ratio de débit d'oxygène par rapport au silane comprise entre 1,4 : 1 et 2,4 : 1 pour déposer un film d'oxyde de silicone sur au moins une partie de ladite surface intérieure de ladite chambre à vide.

8. Un système de traitement de substrat selon la revendication 7, comprenant en outre :
- un système de transfert de substrat configuré pour transférer un substrat dans ladite chambre à vide et positionner ledit substrat sur ledit porte-substrat ;
- un système de génération de plasma configuré pour former un plasma à partir d'un gaz introduit dans ladite chambre à vide ; et
- un contrôleur pour contrôler ledit système de traitement de substrat, ledit système de foumiture de gaz et ledit système de génération de plasma, **caractérisé par** :
- un premier jeu d'instructions pour contrôler ledit système de fourniture de gaz pour introduire un gaz corrosif dans la chambre à vide pour nettoyer ladite surface intérieure de ladite chambre à vide ;
- un deuxième jeu d'instructions devant être exécuté après le premier jeu d'instructions pour contrôler ledit système de fourniture de gaz pour laisser s'écouler dans ladite chambre à vide un gaz de préparation contenant de l'oxygène et du silane dans ladite chambre à vide à une ratio de débit d'oxygène par rapport au silane comprise entre 1,4 : 1 et 2,4 : 1 ;
- un troisième jeu d'instructions pour contrôler ledit système de génération de plasma pour former un plasma à partir dudit gaz de préparation pour déposer un film d'oxyde de silicone sur au moins une partie de ladite surface intérieure de ladite chambre à vide ;
- un quatrième jeu d'instructions devant être exécuté après ledit deuxième et troisième jeu d'instructions pour contrôler ledit système de transfert de substrat pour transférer un substrat dans ladite chambre à vide sur lequel substrat un ou plusieurs circuit intégrés doivent être réalisés et pour positionner ledit substrat sur ledit porte-substrat ; et
- un cinquième jeu d'instructions pour contrôler ledit système de fourniture de gaz pour introduire un gaz de dépôt dans ladite chambre à vide pour déposer une couche sur ledit substrat.
